# EUROPEAN PATENT SPECIFICATION

(11) **EP 1 947 921 B1**
(45) Date of publication and mention of the grant of the patent: **21.10.2009**
(21) Application number: 08000810.5
(22) Date of filing: 17.01.2008
(51) Int. Cl.: H05K 7/20

(54) **Electronic module**
Elektronisches Modul
Module électronique

(30) Priority: 17.01.2007 EP 07000888
(43) Date of publication of application: 23.07.2008
(73) Proprietor: MEN Mikro Elektronik GmbH, 90411 Nürnberg (DE)
(72) Inventor: Schmitz, Manfred, 90547 Stein (DE)
(74) Representative: Prinz & Partner

(56) References cited:
- EP-A- 0 681 422
- US-A- 5 418 685
- US-A- 6 084 776
- US-A- 6 128 189
- US-A1- 2004 233 642

## Description

The invention generally relates to the field of embedded systems, in particular to a so-called "system-on-module".

An embedded system is commonly known as a special-purpose system in which a computer is accommodated in the device it controls. Unlike a general-purpose computer, such as a personal computer, an embedded system performs only one or a few pre-defined tasks, usually with very specific requirements.

A so-called "computer-on-module (COM)" is generally known as a type of single-board computer, i.e. a COM module is a complete computer built on a single circuit board. The design is centered on a single microprocessor with RAM, input/output and all other features needed to be a functional computer on the one board. The module usually needs to be mounted on a carrier board which has standard peripheral connectors.

The term "system-on-module" (SOM) usually refers to more sophisticated solutions including even more functional units on one board which together form a complete system.

There are several standards and specifications defining form factors of the electronic module devices, such as the COM Express (COM.0) specification hosted by the PICMG (PCI Industrial Computer Manufacturers Group) consortium.

If such electronic modules are to be used in harsh environments there is a need for increased mechanical stability and effective cooling of the electronic modules.

From US 5,418,685 an electronic module including the features of the preamble of claim 1 is known. In particular, a multiple parts housing for control devices is provided with a printed circuit board carrying power components and control elements with a peripherally extending lining of electrically and thermally conducting material. The printed circuit board is clamped between the housing halves in the region of the linings. The power components are contacted by the lining so as to be thermally conductive, while control elements which emit interfering radiation or are sensitive to such radiation are enclosed within connecting pieces projecting from the walls of the housing parts.

According to the invention, the above-mentioned need is met by an electronic module, especially a system-on-module, including the features of claim 1..

According to a specific aspect of the invention, one or more devices are provided on the printed circuit board, preferably the device(s) developing the most heat during use of the electronic module, being directly thermally coupled to the casing, in particular to a cover of the casing.

Advantageous and expedient embodiments of the invention are outlined by the subclaims.

Details of the invention will become apparent from the following description of a preferred embodiment and from the accompanying drawings to which reference is made. In the drawings:
- Figure 1 shows an exploded view of an electronic module according to the invention;
- Figure 2 shows a bottom view of the printed circuit board of the electronic module;
- Figure 3 shows a schematic sectional view of the assembled electronic module mounted on the carrier board;
- Figure 4 shows an exploded view of the assembled electronic module and a carrier board;
- Figure 5 shows preferred dimensions of the electronic module in a sectional view; and
- Figure 6 shows preferred dimensions of the electronic module in a top view.

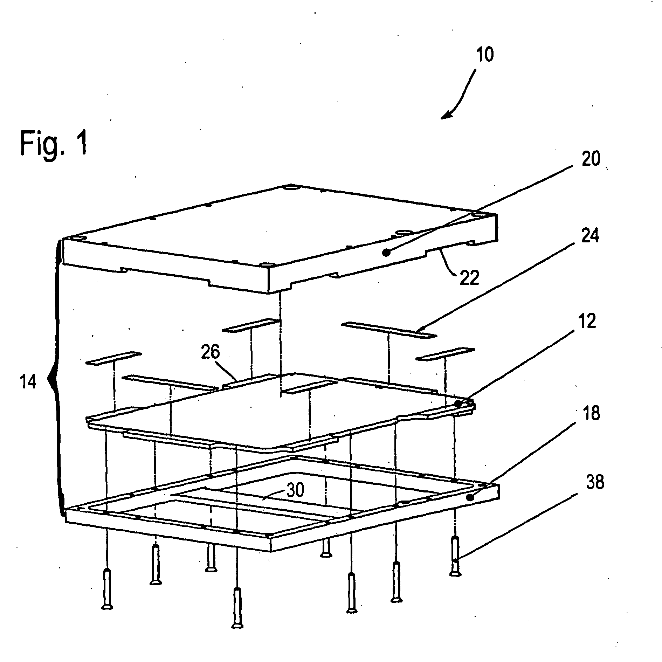

The electronic module 10 depicted in Figure 1 is a system-on-module basically following the COM Express specification. However, in some aspects the electronic module 10 supplements and/or modifies the specification in order to be usable in harsh environments.

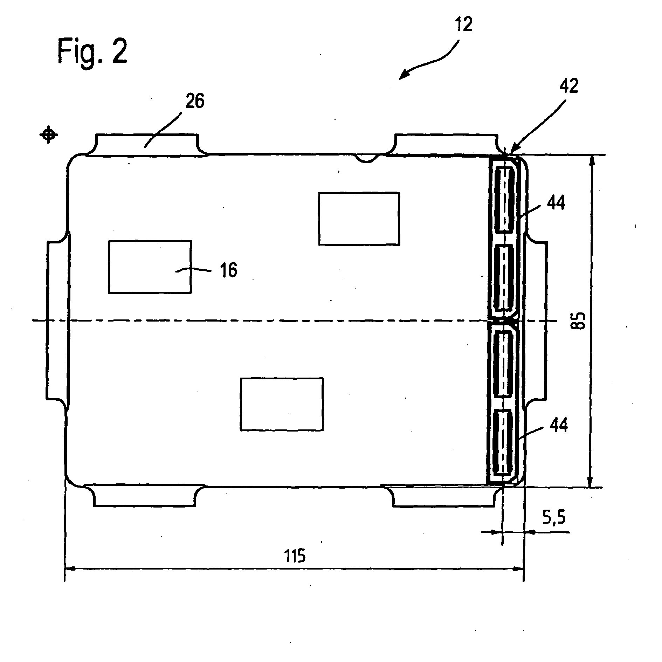

As can be seen in Figure 1 the electronic module 10 is composed of a printed circuit board 12 embedded in a casing 14. The printed circuit board 12, which is shown alone in Figure 2 with preferred dimensions in mm, carries a plurality of electronic devices 16 (not shown in Figure 1) on one or both sides thereof. The casing 14 of the electronic module 10 is made of aluminum, or another electrically conductive material having a relatively low thermal resistance, and includes a frame 18 and a cover 20. The frame 18 and the cover 20 are mounted together by a plurality of screws (described in detail later) so that the frame 18 and the cover 20 are mechanically, thermally and electrically connected.

The connection between the frame 18 and the cover 20 is designed such that approximately 50% of the peripheral surfaces of the frame 18 and the cover 20 opposing each other are in direct contact, while the other approximately 50% are separated from each other by gaps 22. The height of the gaps 22 corresponds to the thickness of the printed circuit board 12 plus the thickness of a compressed gap pad 24. Several of such gap pads 24 are placed on one or both sides (top and/or bottom) of correspondingly shaped extensions 26 of the printed circuit board 12. The extensions 26 and the gap pads 24 are pressed between the frame 18 and the cover 20 when the latter are screwed together. Accordingly, no further parts are necessary to mount the printed circuit board 12 in the casing 14. The gap pads 24 consist of a compressible material having good thermal and electrical conductivities. Thus, the printed circuit board 12 is securely held between the casing components 18, 20, and the printed circuit board 12 is both thermally and electrically connected with the casing components 18, 20.

This construction of the electronic module 10 allows a good heat dissipation from the devices 16 of the printed circuit board 12 via the casing 14 to the environment or to an optional heat sink. The heat conducting concept is referred to as "conductive cooling". Moreover, the electrical connection between the printed circuit board 12 and the casing 14 provides a grounding and shields the printed circuit board 12 with its devices 16.

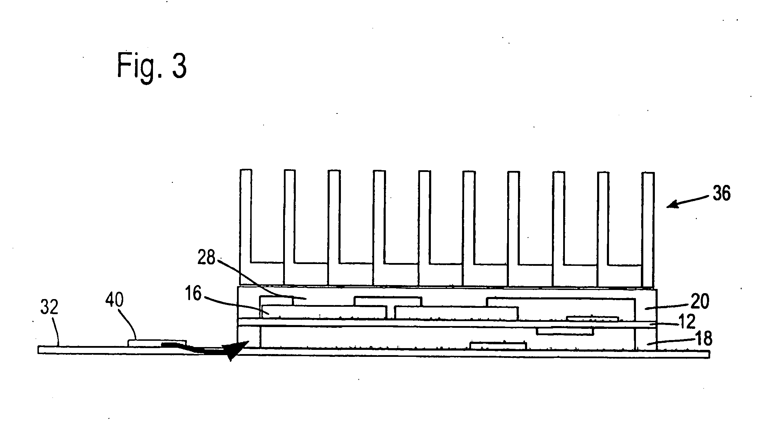

Another measure to improve the cooling effect is to provide a direct thermal coupling of one or more devices 16 of the printed circuit board 12, preferably the device(s) developing the most heat during use of the electronic module 10, to the cover 20 and also to the frame 18 via the surfaces of the cover 20 and the frame 18 contacting each other. The thermal coupling can be established by inwardly extending portions 28 of the cover 20 as shown in Figure 3. In the alternative, or additionally, the shape of the cover 20 is adapted to the respective printed circuit board device(s) 16. In particular, the cover 20 is designed such that it closely follows the contour of the printed circuit board device(s) 16.

In both cases, for reasons of tolerance compensation, a compressible material (not shown) identical or similar to that of the gap pads 24 can be applied between the device(s) 16 and the cover 20. In order to prevent the printed circuit board 12 from being deformed by the mechanical pressure exerted by the compressible material, the frame 18 has a transverse web 30 serving as a hold to receive the pressure.

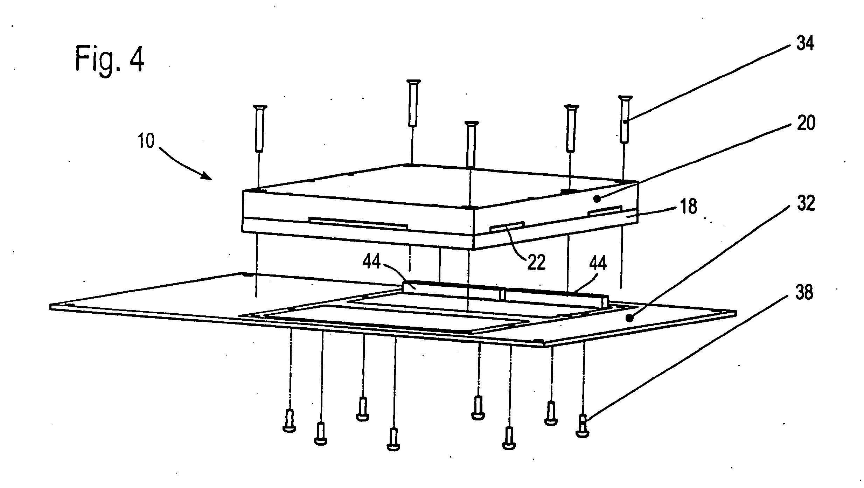

Figure 4 shows how the electronic module 10 is mounted on a carrier board 32. A plurality, preferably five, screws 34 in accordance with the COM Express specification are used to secure the electronic module 10 on the carrier board 32 in a twist-resistant manner. The screws 34, which extend through the cover 20 and the frame 18, can also be used to attach an additional heat sink 36 or cooling element on top of the cover 20 (see Figure 3). In the alternative to those five screws 34, or additionally, the carrier board 32 can be connected directly with the frame 18 of the electronic module 10 by a plurality, preferably eight, screws 38 from the other side as shown in Figure 4.

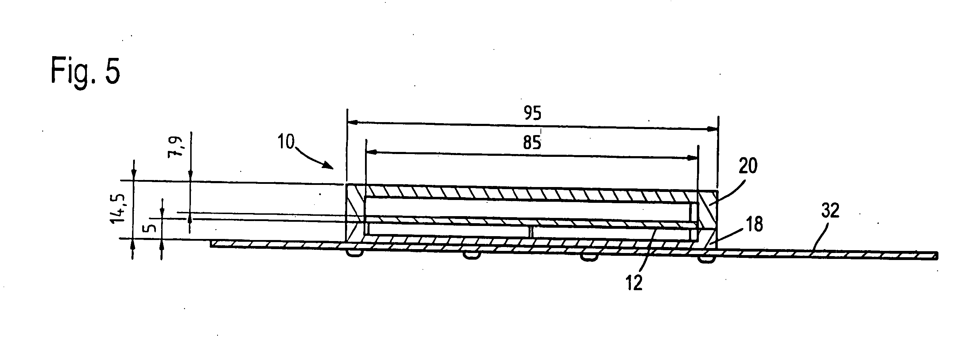

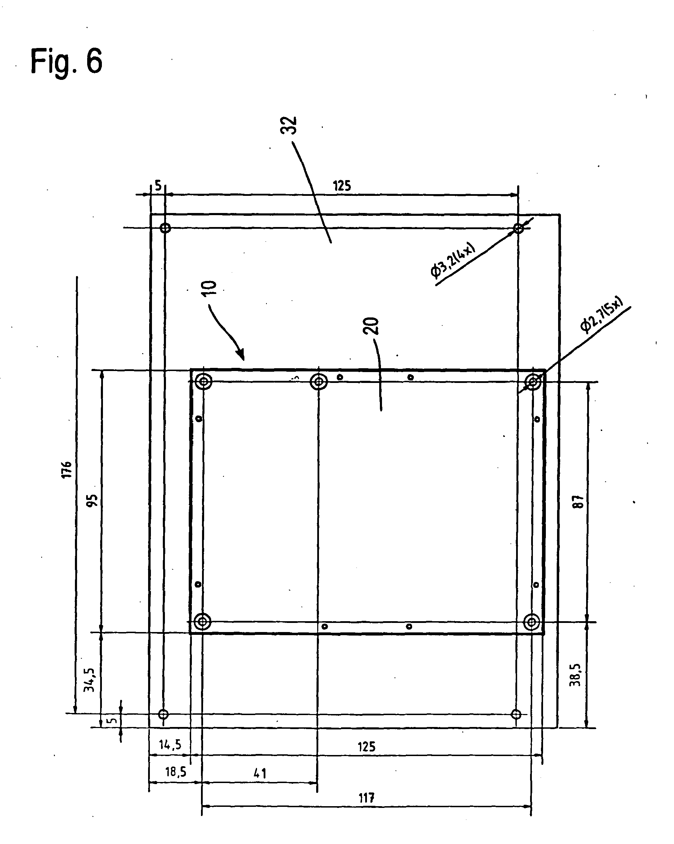

Figures 5 and 6 show the preferred dimensions of the electronic module 10 and its components in mm.

The construction as described above is advantageous in various aspects. The printed circuit board 12 is securely held and supported. The heat of the printed circuit board devices 16 is effectively transferred to the casing 14. Further, heat of devices 40 provided on the carrier board 32 is also transferred to the casing 14 as shown by the arrow in Figure 3. The metal casing 14 shields and grounds the inner components of the electronic module 10. Compatibility to the COM Express specification can be established by means of an adaptor.

The printed circuit board 12 of the electronic module 10 is equipped with a connector arrangement 42 comprising at least two identical, commercially available so-called "highspeed" connectors 44. The use of two or more connectors 44 instead of one large connector is deliberate for the following reason. Printed circuit boards are naturally arched or corrugated. Two smaller connectors 44 can compensate the deformation of the printed circuit board 12 better than a large one. Moreover, the pin assignment is chosen such that less complex electronic modules only need one small connector.

When the electronic module 10 is screwed on the carrier board 32, the connector arrangement 42 of the electronic module 10 automatically engages a matching counterpart connector arrangement of the carrier board 32. Thus, the electric connection between the electronic module 10 and the carrier board 32 is mechanically secured and protected. Detrimental shock and vibration effects as well as dirt is kept away from the connectors.

The pin assignment of the connector arrangement 42 enables connection to modern serial buses like PCI-Express, SATA and USB. In contrast to other commercial system-on-modules in the market, the pin assignment is consistent and binding. For example, certain pins are reserved for eight USB interfaces. These pins have a definite order (numbering). Each carrier board, starting with the lowest number, has to use this bus. If, for example, a carrier board requires two USB connections, the numbers would be 1 and 2. If a carrier board supports four USB interfaces, the numbers would be 1 to 4. This scheme guarantees a maximum compatibility between different electronic modules and carrier boards.

The only power supply of the electronic module 10 is at a 12 V level. This makes the power supply handling easier compared to other commercial electronic modules which often require different voltages (3.3 V, 5 V, 12 V, etc.).

## Claims

1. An electronic module (10), especially a system-on-module, comprising a printed circuit board (12) and a casing (14) made of a material having a low thermal resistance, the casing (14) including at least two casing components (18, 20) that are mounted together, the printed circuit board (12) being pressed between the casing components (18, 20), some of the peripheral surfaces of the casing components (18, 20) opposing each other being in direct contact, the other peripheral surfaces of the casing components (18, 20) being separated from each other by gaps (22), **characterised in that** extended portions (26) of the printed circuit board (12) extend in the gaps (22) and a thermally conductive material is applied on the extended portions (26).

2. The electronic module (10) according to claim 1, **characterised in that** the thermally conductive material is compressible.

3. The electronic module (10) according to claim 1 or 2, **characterised in that** the thermally conductive material is electrically conductive.

4. The electronic module (10) according to one of the preceding claims, **characterised in that** the thermally conductive material is provided in the form of prefabricated pads (24).

5. The electronic module (10) according to one of the preceding claims, **characterized in that** one or more devices (16) are provided on the printed circuit board (12), preferably the device(s) developing the most heat during use of the electronic module (10), being directly thermally coupled to the casing (14), in particular to a cover (20) of the casing (14).

6. The electronic module (10) according to claim 5, **characterised in that** the thermal coupling is at least partially established by inwardly extending portions (28) of the casing (14), in particular of a cover (20) of the casing (14).

7. The electronic module (10) according to claim 5 or 6, **characterised in that** the shape of the casing (14) is adapted to the device(s) (16).

8. The electronic module (10) according to claim 7, **characterised in that** a cover (20) of the casing (14) closely follows the contour of the device(s) (16).

9. The electronic module (10) according to one of claims 5 to 8, **characterised in that** a compressible thermally conductive material is applied between the device(s) (16) and the casing (14), in particular a cover (20) of the casing (14).

10. The electronic module (10) according to one of claims 5 to 9, **characterised in that** the casing (14) includes a frame (18) with a transverse web (30) supporting the printed circuit board (12).

11. The electronic module (10) according to one of the preceding claims, **characterised by** a connector arrangement (42) including at least two identical connectors (44).

12. The electronic module (10) according to one of the preceding claims, **characterised in that** the electronic module (10) is adapted to a single power supply with one specific voltage, preferably 12 V.

13. An electronic assembly, including an electronic module (10) according to one of the preceding claims, **characterised in that** the assembly further comprises a carrier board (32), the casing (14) of the electronic module (10) including a frame (18) and a cover (20), the electronic module (10) being mounted on the carrier board (32) by screws (34) extending through the cover (20) and the frame (18).

14. The electronic assembly according to claim 13, **characterised in that** the screws (34) further attach a heat sink (36) or a cooling element on the cover (20).

15. An electronic assembly, including an electronic module (10) according to one of claims 1 to 13, **characterised in that** the assembly further comprises a carrier board (32), the casing (14) of the electronic module (10) including a frame (18) and a cover (20), the carrier board (32) being connected directly with the frame (18) of the electronic module (10).

16. The electronic assembly according to one of claims 13 to 15, **characterised in that** the electronic module (10) has a first connector arrangement (42) and the carrier board (32) has a matching second connector arrangement, the first and second connector arrangements being positioned such that upon mounting of the electronic module (10) on the carrier board (32) the connector arrangements automatically engage each other.

## Patentansprüche

1. Elektronikmodul (10), insbesondere System-on-Module, mit einer Leiterplatte (12) und einem Gehäuse (14) aus einem Material mit einem niedrigen Wärmewiderstand, wobei das Gehäuse (14) wenigstens zwei aneinander befestigte Gehäusebauteile (18, 20) aufweist, wobei die Leiterplatte (12) zwischen die Gehäusebauteile (18, 20) gedrückt ist, wobei einige der Umfangsflächen der einander gegenüberliegenden Gehäusebauteile (18, 20) einander unmittelbar berühren, wobei die anderen Umfangsflächen der Gehäusebauteile (18, 20) durch Spalte (22) voneinander getrennt sind, **dadurch gekennzeichnet, dass** sich Fortsätze (26) der Leiterplatte (12) in die Spalte (22) erstrecken und auf den Fortsätzen (26) ein wärmeleitfähiges Material angebracht ist.

2. Elektronikmodul (10) nach Anspruch 1, **dadurch gekennzeichnet, dass** das wärmeleitfähige Material komprimierbar ist.

3. Elektronikmodul (10) nach Anspruch 1 oder 2, **dadurch gekennzeichnet, dass** das wärmeleitfähige Material elektrisch leitfähig ist.

4. Elektronikmodul (10) nach einem der vorhergehenden Ansprüche, **dadurch gekennzeichnet, dass** das wärmeleitfähige Material in Form von vorgefertigten Anschlussstellen (24) vorgesehen ist.

5. Elektronikmodul (10) nach einem der vorhergehenden Ansprüche, **dadurch gekennzeichnet, dass** auf der Leiterplatte (12) ein oder mehrere Bauelemente (16) vorgesehen sind, wobei vorzugsweise das bzw. die Bauelement(e), das bzw. die während des Gebrauchs des Elektronikmoduls (10) am meisten Wärme entwickelt bzw. entwickeln, thermisch unmittelbar mit dem Gehäuse (14), insbesondere mit einem Deckel (20) des Gehäuses (14) gekoppelt ist bzw. sind.

6. Elektronikmodul (10) nach Anspruch 5, **dadurch gekennzeichnet, dass** die thermische Kopplung wenigstens teilweise durch sich nach innen erstreckende Abschnitte (28) des Gehäuses (14), insbesondere eines Deckels (20) des Gehäuses (14), hergestellt ist.

7. Elektronikmodul (10) nach Anspruch 5 oder 6, **dadurch gekennzeichnet, dass** die Form des Gehäuses (14) an das bzw. die Bauelement(e) (16) angepasst ist.

8. Elektronikmodul (10) nach Anspruch 7, **dadurch gekennzeichnet, dass** ein Deckel (20) des Gehäuses (14) eng auf die Kontur des Bauelements bzw. der Bauelemente (16) abgestimmt ist.

9. Elektronikmodul (10) nach einem der Ansprüche 5 bis 8, **dadurch gekennzeichnet, dass** ein komprimierbares, wärmeleitfähiges Material zwischen dem bzw. den Bauelement(en) (16) und dem Gehäuse (14), insbesondere einem Deckel (20) des Gehäuses (14), angebracht ist.

10. Elektronikmodul (10) nach einem der Ansprüche 5 bis 9, **dadurch gekennzeichnet, dass** das Gehäuse (14) einen Rahmen (18) mit einem Quersteg (30) aufweist, der die Leiterplatte (12) abstützt.

11. Elektronikmodul (10) nach einem der vorhergehenden Ansprüche, **gekennzeichnet durch** eine Steckverbinderanordnung (42) mit wenigstens zwei identischen Steckverbindern (44).

12. Elektronikmodul (10) nach einem der vorhergehenden Ansprüche, **dadurch gekennzeichnet, dass** das Elektronikmodul (10) auf eine einzige Stromversorgung mit einer bestimmten Spannung, vorzugsweise 12 V, eingestellt ist.

13. Elektronikbaugruppe mit einem Elektronikmodul (10) nach einem der vorhergehenden Ansprüche, **dadurch gekennzeichnet, dass** die Baugruppe ferner eine Trägerplatte (32) umfasst, wobei das Gehäuse (14) des Elektronikmoduls (10) einen Rahmen (18) und einen Deckel (20) aufweist, wobei das Elektronikmodul (10) mit Schrauben (34), die sich durch den Deckel (20) und den Rahmen (18) erstrecken, auf der Trägerplatte (32) befestigt ist.

14. Elektronikbaugruppe nach Anspruch 13, **dadurch gekennzeichnet, dass** mit den Schrauben (34) ferner ein Kühlkörper (36) oder ein Kühlelement an dem Deckel (20) angebracht ist.

15. Elektronikbaugruppe mit einem Elektronikmodul (10) nach einem der Ansprüche 1 bis 13, **dadurch gekennzeichnet, dass** die Baugruppe ferner eine Trägerplatte (32) umfasst, wobei das Gehäuse (14) des Elektronikmoduls (10) einen Rahmen (18) und einen Deckel (20) aufweist, wobei die Trägerplatte (32) unmittelbar mit dem Rahmen (18) des Elektronikmoduls (10) verbunden ist.

16. Elektronikbaugruppe nach einem der Ansprüche 13 bis 15, **dadurch gekennzeichnet, dass** das Elektronikmodul (10) eine erste Steckverbinderanordnung (42) und die Trägerplatte (32) eine dazu passende, zweite Steckverbinderanordnung aufweist, wobei die erste und die zweite Steckverbinderanordnung so positioniert sind, dass die Steckverbinderanordnungen bei der Befestigung des Elektronikmoduls (10) an der Trägerplatte (32) automatisch ineinandergreifen.

## Revendications

1. Module électronique (10), en particulier système sur module, comportant une carte de circuits imprimés (12) et un boîtier (14) en un matériau présentant une faible résistance thermique, le boîtier (14) comportant au moins deux composants de boîtier (18, 20) fixés l'un à l'autre, la carte de circuits imprimés (12) étant serrée entre les composants de boîtier (18, 20), certaines des surfaces périphériques des composants de boîtier (18, 20) opposés l'un à l'autre étant en contact direct, les autres surfaces périphériques des composants de boîtier (18, 20) étant séparées les unes des autres par des fentes (22), **caractérisé en ce que** des prolongements (26) de la carte de circuits imprimés (12) s'étendent dans les fentes (22) et **en ce qu'**un matériau thermoconducteur est appliqué sur les prolongements (26).

2. Module électronique (10) selon la revendication 1, **caractérisé en ce que** le matériau thermoconducteur est compressible.

3. Module électronique (10) selon la revendication 1 ou 2, **caractérisé en ce que** le matériau thermoconducteur est électroconducteur.

4. Module électronique (10) selon l'une des revendications précédentes, **caractérisé en ce que** le matériau thermoconducteur est prévu sous forme de plots préfabriqués (24).

5. Module électronique (10) selon l'une des revendications précédentes, **caractérisé en ce qu'**un ou plusieurs dispositif(s) (16) est/sont prévu(s) sur la carte de circuits imprimés (12), le/les dispositif(s) développant de préférence le plus de chaleur lors de l'utilisation du module électronique (10) et étant thermiquement directement relié(s) au boîtier (14), en particulier à un couvercle (20) du boîtier (14).

6. Module électronique (10) selon la revendication 5, **caractérisé en ce que** la liaison thermique est au moins partiellement établie par des tronçons (28) du boîtier (14), en particulier d'un couvercle (20) du boîtier (14), qui s'étendent vers l'intérieur.

7. Module électronique (10) selon la revendication 5 ou 6, **caractérisé en ce que** la forme du boîtier (14) est adaptée au(x) boîtier(s) (16).

8. Module électronique (10) selon la revendication 7, **caractérisé en ce qu'**un couvercle (20) du boîtier (14) suit le contour du/des dispositif(s) (16) de façon serrée.

9. Module électronique (10) selon l'une des revendications 5 à 8, **caractérisé en ce qu'**un matériau thermoconducteur et compressible est appliqué entre le/les dispositif(s) (16) et le boîtier (14), en particulier un couvercle (20) du boîtier (14).

10. Module électronique (10) selon l'une des revendications 5 à 9, **caractérisé en ce que** le boîtier (14) présente un cadre (18) avec une traverse (30) supportant la carte de circuits imprimés (12).

11. Module électronique (10) selon l'une des revendications précédentes, **caractérisé par** un agencement de connecteurs (42) présentant au moins deux connecteurs (44) identiques.

12. Module électronique (10) selon l'une des revendications précédentes, **caractérisé en ce que** le module électronique (10) est adapté pour une seule alimentation en courant avec une tension spécifique, de préférence 12 V.

13. Ensemble électronique comportant un module électronique (10) selon l'une des revendications précédentes, **caractérisé en ce que** l'ensemble présente en outre une plaque support (32), le boîtier (14) du module électronique (10) présentant un cadre (18) et un couvercle (20), le module électronique (10) étant monté sur la plaque support (32) au moyen de vis (34) s'étendant à travers le couvercle (20) et le cadre (18).

14. Ensemble électronique selon la revendication 13, **caractérisé en ce que** les vis (34) attachent en outre un puits thermique (36) ou un élément de refroidissement au couvercle (20).

15. Ensemble électronique comportant un module électronique (10) selon l'une des revendications 1 à 13, **caractérisé en ce que** l'ensemble présente en outre une plaque support (32), le boîtier (14) du module électronique (10) comportant un cadre (18) et un couvercle (20), la plaque support (32) étant directement reliée au cadre (18) du module électronique (10).

16. Ensemble électronique selon l'une des revendications 13 à 15, **caractérisé en ce que** le module électronique (10) présente un premier agencement de connecteurs (42) et **en ce que** la plaque support (32) présente un deuxième agencement de connecteurs correspondant, les premier et deuxième agencements de connecteurs étant positionnés de telle sorte que lors du montage du module électronique (10) sur la plaque support (32), les agencements de connecteurs s'engagent automatiquement l'un dans l'autre.
